# EUROPEAN PATENT SPECIFICATION

(11) **EP 3 815 152 B1**
(45) Date of publication and mention of the grant of the patent: **03.09.2025**
(21) Application number: 19825137.3
(22) Date of filing: 01.07.2019
(51) Int. Cl.: H02S 20/32, H02S 40/22

(54) **SOLAR MODULE TRACKER SYSTEM OPTIMIZED FOR BIFACIAL SOLAR MODULES**
SOLARMODULTRACKER-SYSTEM OPTIMIERT FÜR ZWEISEITIGE SOLARMODULE
SYSTÈME DE SUIVEUR DE MODULE SOLAIRE OPTIMISÉ POUR DES MODULES SOLAIRES BIFACIAUX

(30) Priority: 29.06.2018 US 201862692200 P
(43) Date of publication of application: 05.05.2021
(73) Proprietor: Nextracker LLC, Fremont, CA 94555 (US)
(72) Inventor: BEARDSWORTH, Greg, Berkeley, California 94702 (US); ABBARAJU, Venkata, Fremont, California 94536 (US); SHUGAR, Daniel, Pacifica, California 94044 (US)
(74) Representative: v. Bezold & Partner Patentanwälte - PartG mbB
(86) International application number: PCT/US2019/040208
(87) International publication number: WO 2020/006575

(56) References cited:
- US-A1- 2007 277 810
- US-A1- 2008 230 047
- US-A1- 2008 230 047
- US-A1- 2011 114 153
- US-A1- 2014 116 495
- US-A1- 2016 359 447
- US-A1- 2018 062 563
- US-B2- 9 654 053

## Description

### Technical Field

This present disclosure relates to solar energy production. More specifically a solar module design incorporating light management that increases power output for the same or less amount of silicon solar cells.

### Background of the Present Disclosure

Solar power is accelerating as a mainstream power generation source in global markets. In order to further broaden its economic value, greater productivity of solar power system is desired by customers. Crystalline solar photovoltaic systems predominantly capture light on the front side of solar panels, on the front "face", which can be considered "monofacial" solar panels. One method to increase power production is to harvest reflected light from the ground on the back side of the solar panels, on to special solar cells, that are designed to harvest "bifacial" energy. Bifacial solar panels have been used in the solar industry for over 10 years.

In this context, US 2007/277810 A1 discloses a solar panel having a panel front and a panel back, comprising an array of solar cells and an element comprising a visually distinguishable feature. Each of the solar cells has a front and a back, wherein at least the front is capable of converting at least a portion of solar light incident thereon into electrical energy. There are spacings between at least some of the solar cells. The element comprising the visually distinguishable feature is located at at least one position selected from the group consisting of between the panel back and the panel front, on the panel front, on the panel back, at the panel front, and at the panel back, such that the visually distinguishable feature is at least partially distinguishable on viewing the panel front. The nature of the visually distinguishable feature and/or the location of the element relative to the solar cells does not completely prevent solar light incident on the panel front from being incident on at least a portion of the array.

Furthermore, US 2008/230047 A1 discloses a solar collector assembly, which includes a frame supporting a solar collector and a frame member defining a tilted pivot axis. Support struts may be used to elevate one end of the frame and may be pivoted between an orientation generally parallel to the frame member and to an orientation generally away from the frame. Anchorless, ballast type bases may be used to support the solar collector assembly. Several assemblies may be stacked on top of one another in a storage or transportation configuration using spacers extending between the frames.

There are several key limitations on the design of bifacial solar panels that limit their utility. Initially, there is light loss through the solar panel, around the crystalline solar cells, impacted front side power. Typical crystalline modules have significant areas between the cells, that are not covered by active solar cell material. Light entering these zones on a monofacial modules is largely reflected, and scattered, by standard white backsheets, and partially recovered through total internal refection (TIR) onto the front sides of solar cells. On bifacial modules however, this light energy is lost because the backside of the solar panel is transparent, per design, to allow the back of the cells to receive light. While this is necessary for rear side bifaciality, front side power suffers, approximately 3-5%. This is significant loss of power.

A bifacial solar panel array provides an opportunity for enhanced collection from these dead spaces through the use of more specific reflecting surfaces. The present disclosure addresses all of these shortcomings of the known systems.

### Summary

The present disclosure is directed to systems and methods for increasing power output from a solar module containing bifacial solar cells by increasing the gap between solar cells arranged along the centerline of the module such that light can pass there through. The light impacts a torque located on a backside of the solar module and is reflected back in the direction of the solar module to be absorbed and converted to electrical energy by the solar cells on the backside of the solar module. The location of the torque tube a specified distance from the solar module improves the yield of the recovered solar energy by the back side of the bifacial solar module.

One general aspect (not an embodiment of the invention) includes a solar module including: a frame, a plurality of bifacial solar cells supported by the frame. The solar module also includes a gap formed between two or more of the solar cells, the gap being formed proximate a centerline of the solar module and configured to a allow passage of light from a first side of the solar module to a second side of a solar module, where the light passing through the gap is reflected back onto the plurality of bifacial solar cells and converted to electrical energy.

Implementations may include one or more of the following features. The solar module where the gap is between 5 and 25 mm. The solar module where the gap is between 10 and 20 mm. The solar module where the gap is between 10 and 15 mm. The solar module where the gap is 10 mm. The solar module where absorption of the reflected light passing through the gap increases backside irradiance by between 5 and 15 percent. The solar module where absorption of the reflected light passing through the gap increases backside irradiance by between 5 and 10 percent. The solar module where absorption of the reflected light passing through the gap increases backside irradiance by about 10 percent.

One general aspect according to the invention as recited in claim 1, includes a solar tracker including: a torque tube. The solar tracker also includes a plurality of solar modules mounted on the torque tube, each solar module including a plurality of solar cells. The solar tracker also includes a gap formed between at least two solar cells, the gap configured to allow light to impact the torque tube and be reflected onto a backside of the plurality of solar modules, wherein the gap is formed between adjacent solar cells within a single module.

Implementations may include one or more of the following features. The solar tracker where the gap is formed between adjacent solar modules is not part of the present invention. The solar tracker where the plurality of solar modules are mounted about 90 mm above the torque tube. The solar tracker where the gap is between 5 and 25 mm. The solar tracker where the gap is between 10 and 20 mm. The solar tracker where the gap is between 10 and 15 mm. The solar tracker where the gap is 10 mm. The solar tracker where absorption of the reflected light passing through the gap increases backside irradiance by between 5 and 15 percent. The solar tracker where absorption of the reflected light passing through the gap increases backside irradiance by between 5 and 10 percent. The solar tracker where absorption of the reflected light passing through the gap increases backside irradiance by about 10 percent.

### Brief Description of Drawings

Figure 1 depicts a perspective backside view of a solar tracker with bifacial modules and the reflection of light off the torque tube of the solar tracker onto the back side of the solar module according to the invention;
Figure 2 depicts an end view of a solar tracker and solar module receiving solar energy reflected from the ground and the torque tube of the tracker according to the invention;
Figure 3A depicts a graphical representation of the captured irradiance of the backside of a solar module employing the system of the present invention.
Fig. 3B depicts a test apparatus (not an embodiment of the invention) in accordance with the present disclosure.
Fig. 3C depicts a graph of the backside irradiance based on different mid-line gap sizes.
Figure 4A depicts a front side view of a solar module (not an embodiment of the invention);
Figure 4B depicts the frame of a solar module (not an embodiment of the invention);
Figure 4C depicts a detailed view of the front side view of a solar module along an edge of the solar module (not an embodiment of the invention);
Figure 4D depicts a detailed view of the front side view of a solar along the center line of the solar module (not an embodiment of the invention);

### Detailed Description of the Present Disclosure

The present disclosure is directed to systems and methods for increasing the energy yield of bifacial solar modules. In accordance with certain aspects of the present disclosure, the bifacial solar modules are employed with single axis solar tracker devices, however, other applications are considered within the scope of the present disclosure, including fixed position installations dual axis solar trackers and others.

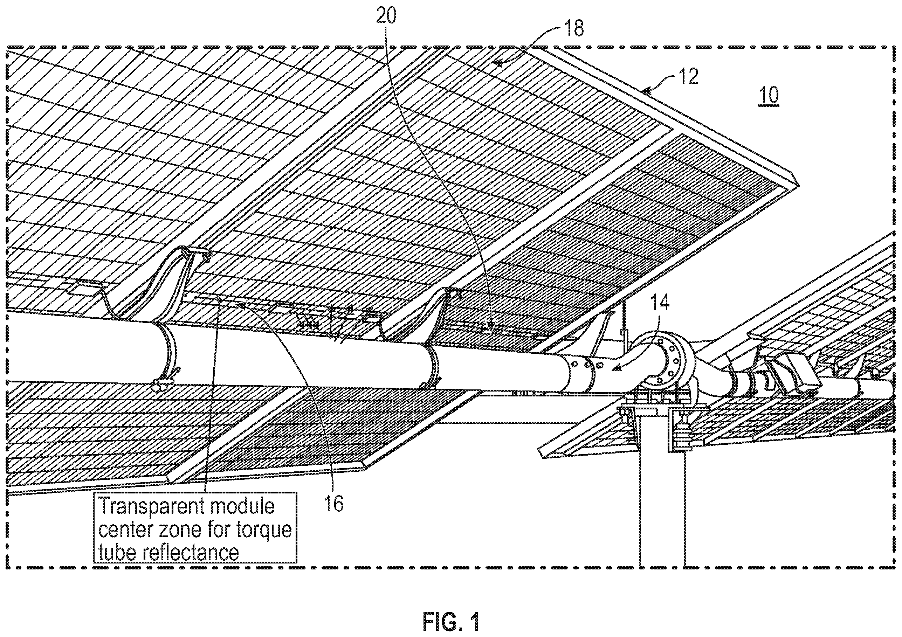

Fig. 1 shows an embodiment of the present disclosure incorporated in a solar tracker 10 according to the invention. The solar tracker 10 includes solar modules 12 mounted on a torque tube 14. The solar modules 12 include a gap 16 formed substantially along the centerline of the solar module 12. Though not depicted, gaps may also be formed along the edges of the solar module 12 and the light passing through those gaps may be reflected back to the solar cell of the solar module 12 by the frame of the solar module 12 and other means as described in commonly owned PCT Application No. PCT/US2019/027278 entitled LIGHT MANAGEMENT SYSTEMS FOR OPTIMIZING PERFORMANCE OF BIFACIAL SOLAR MODULES, filed April 12, 2019. The gap 16 is formed on the module so that it substantially corresponds with the position of the torque tube 14. The gap 16 is a clear space (e.g., just clear glass) formed along the centerline of the bifacial solar module. As can be seen, the light passes through the solar module 12 and impacts the torque tube 14 of the solar tracker 10. Typically, the torque tube 14 is made of a galvanized steel that has some reflective properties. The reflectivity of the torque tube 14 can be enhanced by the use of reflective tapes, paints, or other materials placed on the torque tube in appropriate locations. These may be metallic, white, or any reflective color.

As show the torque tube 14 has a circular cross-section, this cross section is advantageous in directing the reflected light at an angle to the direction of the incoming light. The result is that the light is reflected away from the centerline of the torque tube 14 in fan like pattern (as shown) and can be readily absorbed by the back side solar cells of the bifacial module. Minimal light is reflected directly back towards the gap in the solar module, and thus potentially lost, however, even some of this is captured by the glass in the gap 16 and reflected again onto the front side solar cells of the solar module 12.

The torque tube 14, however, need to necessarily be round to benefit from the present disclosure. Other shapes including square, rectangular, hexagonal, etc., can also benefit from the present disclosure. Such torque tubes may include reflective materials placed on the flats to help spread the angle of reflection of the light impacting the torque tube.

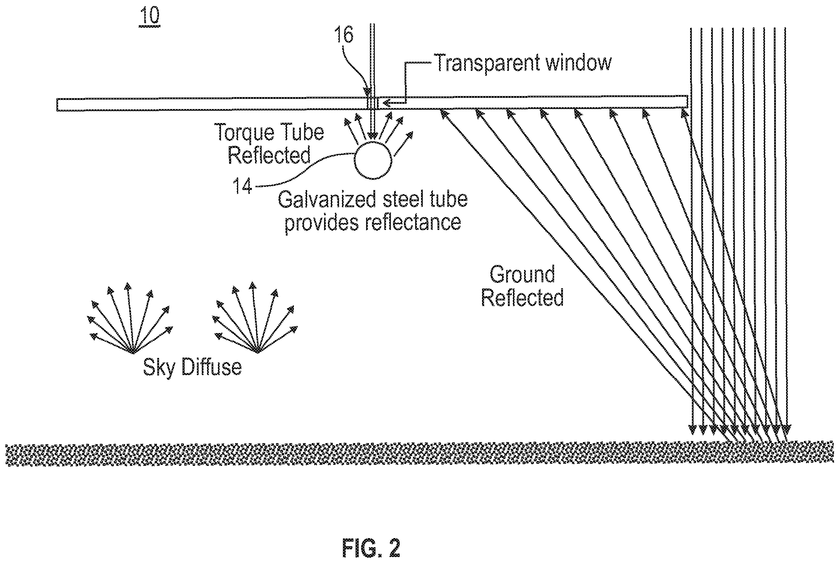

Fig. 2 depicts schematically the operation of the backside of a bifacial solar module in the 0 position (approximately where the module should be at noon with the sun directly overhead). Sunlight impacts the solar module 12 on the front side and is absorbed to generate electrical energy. Sunlight beyond the edges of the solar module 12 impacts the ground and is reflected onto the underside of the solar module 12 to be absorbed by the back side of the bifacial solar module 12. In addition, diffuse light which might be reflected from many surfaces or simply part of the ambient light levels associated with the sun being above the horizon, whether on a sun filled or cloudy day can be absorbed by either side of the solar module 12. Finally, at the mid-point of the solar module 12 the gap 16 allows light to pass through the solar module 12 and be reflected back onto the back side of the solar module 12 to be absorbed and converted to electrical energy. The gap 16, as noted above, may be in the form of a transparent window formed into the solar module 12. In some instances, this transparent window if formed of one or both the glass plates that make up the front side and back side of the solar module 12. In other instances, the gap 16 may be a separation between two solar modules 12. This may be particularly useful when a two-portrait orientation of the solar modules is employed. The gap between the two solar modules allows light to impact the torque tube 14 and reflect onto the back sides of the solar modules 12.

Further, as can be seen in Fig. 2, some portion of the light that reflects off the ground may be blocked by the torque tube 14. This blocking creates shading on the back sides of certain cells in the solar module 12. Shading is one of the greatest factors in overall performance of a solar module, with a shaded cell causing at minimum that cell to have its bypass diode activated resulting in no energy production from that cell. In other instances, where a single by-pass diode is used of a series of solar cells, shading can result in even greater impacts to the power production and efficiency of the solar module 12. The effects of back-side shading caused by the torque tube 14 can be greatly reduced by use of the gap 16. While the shading still occurs, in that the reflected light impacts the torque tube 14 and not the solar module 12, the light that passes through the gap 16 is reflected onto the very same surfaces that would otherwise experience shading. This results in an overall improvement in the electrical energy production from the solar module 12 by reducing this shading experienced by the solar module 12.

A variety of gap widths have been investigated from 0-25 mm. In one such test, the gap 16 in the solar module 12 was simulated at various distances. Testing was performed at around the noon-hour, when the sun is directly overhead. Irradiance was measured on six occasions each with a different gap size as shown in Table 1.

**Table 1 - Irradiance increases with gap size change**

| Sample | Time 1 | Time 2 | Time 3 | Time 4 | Time 5 | Time 6 |
|---|---|---|---|---|---|---|
| GAP SIZE | 0mm | 5mm | 10mm | 15mm | 20mm | 25mm |
| Irrad gain w/ gap | 0.0 | 5 | 10 | 12 | 15 | 16 |
| Percent gain on the backside w/ gap | 0 | 6 | 10 | 11 | 12 | 13 |

The result of these experiments demonstrated that when the size of the gap is kept within a specified size, there is a decrease in backside shading caused by the torque tube 14, and an overall increase in irradiance impacting the solar module 12. Further it was recognized that because increasing the gap 16 size results in loss of front side solar energy collection, the gains from the backside need to be considered in combination with these potential losses. The result is that a 10 mm gap, results in sufficient increases in yield that is not offset by front side losses, to make it a desirable compromise for the tested cells and modules.

It is expected that similar results will be achieved for a dirty torque tubes 14 (as it might be found in the field), a cleaned torque tube, a white painted torque tube, and a torque tube with reflective aluminum tape applied there to. In general, the increase in back side irradiance with the gap is between 1 and 15 percent, preferably between 5 and 13 percent, more preferably between 5 and 10 percent, and most preferably about 10 percent. Total irradiance gains by use of the gap may be between 5 and 20, preferably between 5 and 15, more preferably between 10 and 15, and most preferably about 10.

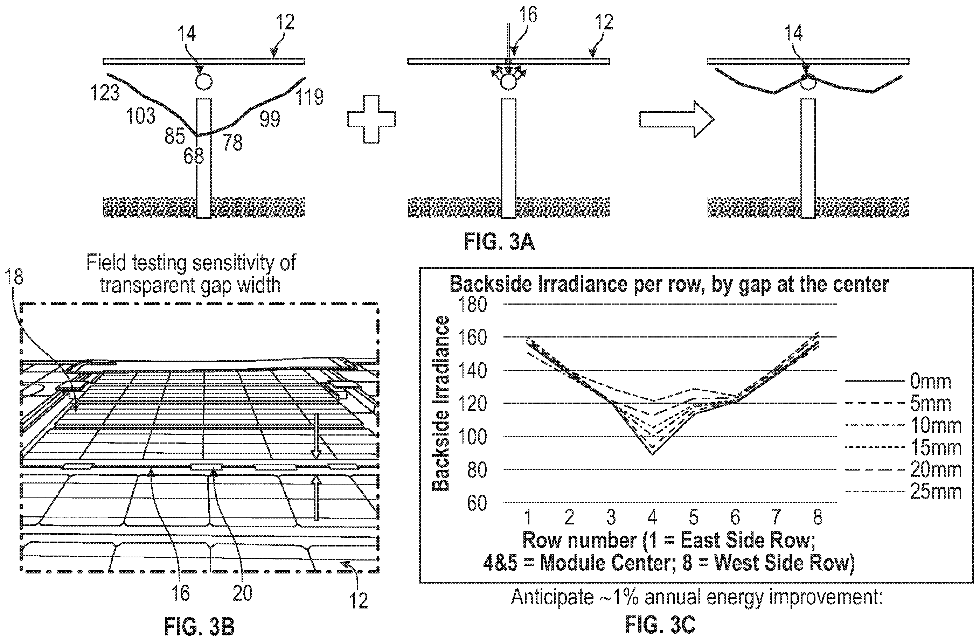

Fig. 3A depicts graphically the result of adding the gap to the solar module with respect to the increases in irradiance on the back side of the solar module. The first frame of Fig. 3A depicts the tracker 10 (not an embodiment of the invention) with the solar modules 12 in the noon or 0 position. The numbers in the first frame of Fig. 3A are the irradiance measurement of the backs side of the bifacial solar module across the width of the solar module 12. As expected, due to shading and distance from the edges of the solar module 12, the center of the solar module experiences less irradiance than the edges. Thus, in the example shown in the first frame of Fig. 3A, the center of the solar module 12 experiences about half of the irradiance of the edges. This difference in irradiance has a direct correlation to the energy produced by the solar module 12. The center frame of Fig. 3A depicts the addition of the gap 16 as proposed by the instant invention, and the additional reflected light paths being reflected off the torque tube 14 and on to the back side of the solar module 12. The third frame of Fig. 3A depicts a graph of the resultant irradiance measurements experienced by the backside of the solar module 12 when the gap 16 is employed. As can be seen, there is a dramatic increase in irradiance and instead of having a single trough, the graph has a middle peak and two much shallower troughs. This change in irradiance has a direct correlation to the overall output of the solar module 12.

Fig. 3B depicts a solar module 12 (not an embodiment of the invention). The solar module 12 is made up of several cells 18 connected in series and parallel as is known in the art. Along the centerline of the solar module 12 are a series of junction boxes 20 which are also commonly used to electrically connect cells 18 and strings of cells 18. On either side of these junction boxes 20 are the gaps 16 formed in the solar module 12 which allow light to pass through the solar module 12 and impact the torque tube 14 beneath (not shown in Fig. 3B).

Fig. 3C depicts a graph of the irradiance measurements which resulted in Table 1. With the addition of a gap 16 the irradiance measured increased in the middle portion of the solar module 12, and eventually experienced the middle peak and two-trough scenario observed in the third frame of Fig. 3A.

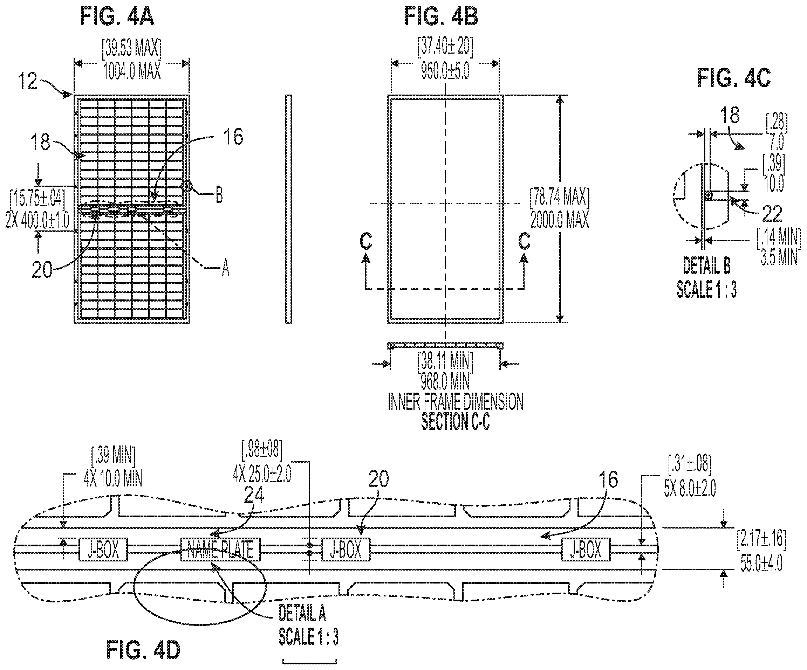

Fig. 4A depicts a front side of the solar module 12 having a gap 16 in accordance with the present disclosure (not an embodiment of the invention). As can be seen, the gap 16 is formed on either side of the junction boxes 20 placed along the centerline of the solar module 12.

Fig. 4B depicts a back side of the solar module 12, however, the solar cells are not expressly shown. This view primarily shows the frame of the solar module 12. Fig. 4C depicts a close-up view of the solar module 12 at position B in Fig. 4A. This view shows smaller gaps 22 that may be formed between the cells 18. Fig. 4D depicts a close-up view of the centerline of the solar module 12 in Fig. 4A. In particular this view shows the relative position of the junction boxes 20 and the gaps 16 through which light passes and impacts the torque tube 14, not shown. A name plate 24 may also be formed proximate the centerline of the solar module 12.

A further observation of the present disclosure is that there must be some distance between the torque tube 14 and the solar module 12. This distance can be seen in Figs. 1 and 2, and its purpose is to permit the reflection and absorption of the light by the backside solar cells of the bifacial solar module 12. In accordance with one aspect of the disclosure the space is between 5 and 150mm, preferably between 15 and 120 mm, more preferably between 30 and 90 mm, still more preferably between 60 and 90mm and in at least one example 90 mm. At these distances, the light impacting the torque tube is reflected at angles that allow for a broad array of reflection and absorption of the solar cells of the backside of the bifacial solar module. Moreover, this separation helps to reduce or eliminate potential shading by the torque tube of the light reflected off the ground or other sources.

Though particular embodiments have been described in detail herein above, the features and aspects of the various embodiments may be used together and separately in a variety of forms without departing from the scope of the present disclosure.

## Claims

1. A solar tracker (10) comprising:
a torque tube (14);
a plurality of solar modules (12) mounted on the torque tube (14), each solar module including a plurality of solar cells (18); and
a gap (16) formed between at least two solar cells (18), the gap (16) configured to allow light to impact the torque tube (14) and be reflected onto a backside of the plurality of solar modules (12), wherein the gap (16) is formed between adjacent solar cells (18) within a single solar module (12).

2. The solar tracker (10) of claim 1, wherein the plurality of solar modules (12) are mounted about 90 mm above the torque tube (14).

3. The solar tracker (10) of claim 1, wherein the gap (16) is between 5 and 25 mm, preferably between 10 and 20 mm, more preferably between 10 and 15 mm, and most preferably 10 mm.

4. The solar tracker (10) of claim 1, wherein absorption of the reflected light passing through the gap (16) increases backside irradiance by between 5 and 15 percent.

5. The solar tracker (10) of claim 1, wherein absorption of the reflected light passing through the gap (16) increases backside irradiance by between 5 and 10 percent.

6. The solar tracker (10) of claim 1, wherein absorption of the reflected light passing through the gap (16) increases backside irradiance by about 10 percent.

## Patentansprüche

1. Solartracker (10), aufweisend:
ein Drehrohr (14);
eine Mehrzahl von Solarmodulen (12), die auf dem Drehrohr (14) montiert ist, wobei jedes Solarmodul eine Mehrzahl von Solarzellen (18) aufweist; und
einen Spalt (16), der zwischen mindestens zwei Solarzellen (18) ausgebildet ist, wobei der Spalt (16) dazu ausgebildet ist, zu ermöglichen, dass Licht auf das Drehrohr (14) auftreffen und auf eine Rückseite der Mehrzahl von Solarmodulen (12) reflektiert werden kann, wobei der Spalt (16) zwischen benachbarten Solarzellen (18) innerhalb eines einzelnen Solarmoduls (12) ausgebildet ist.

2. Solartracker (10) nach Anspruch 1, wobei die Mehrzahl von Solarmodulen (12) etwa 90 mm über dem Drehrohr (14) montiert ist.

3. Solartracker (10) nach Anspruch 1, wobei der Spalt (16) zwischen 5 und 25 mm, vorzugsweise zwischen 10 und 20 mm, noch bevorzugter zwischen 10 und 15 mm und am meisten bevorzugt 10 mm beträgt.

4. Solartracker (10) nach Anspruch 1, wobei die Absorption des durch den Spalt (16) hindurchtretenden reflektierten Lichts die Rückseitenbestrahlungsstärke um 5 bis 15 Prozent erhöht.

5. Solartracker (10) nach Anspruch 1, wobei eine Absorption des durch den Spalt (16) hindurchtretenden reflektierten Lichts die Rückseitenbestrahlungsstärke um 5 bis 10 Prozent erhöht.

6. Solartracker (10) nach Anspruch 1, wobei eine Absorption des durch den Spalt (16) hindurchtretenden reflektierten Lichts die Rückseitenbestrahlungsstärke um etwa 10 Prozent erhöht.

## Revendications

1. Suiveur solaire (10) comprenant :
un tube de couple (14) ;
une pluralité de modules solaires (12) montés sur le tube de couple (14), chaque module solaire comprenant une pluralité de cellules solaires (18) ; et
un espace (16) formé entre au moins deux cellules solaires (18), l'espace (16) étant configuré pour permettre à la lumière d'impacter le tube de couple (14) et d'être réfléchie sur une face arrière de la pluralité de modules solaires (12), l'espace (16) étant formé entre des cellules solaires adjacentes (18) à l'intérieur d'un seul module solaire (12).

2. Suiveur solaire (10) selon la revendication 1, la pluralité de modules solaires (12) étant montés à environ 90 mm au-dessus du tube de couple (14).

3. Suiveur solaire (10) selon la revendication 1, l'espace (16) étant compris entre 5 et 25 mm, de préférence entre 10 et 20 mm, plus préférablement entre 10 et 15 mm, et le plus préférablement 10 mm.

4. Suiveur solaire (10) selon la revendication 1, l'absorption de la lumière réfléchie passant à travers l'espace (16) augmentant l'irradiance de la face arrière de 5 à 15 pour cent.

5. Suiveur solaire (10) selon la revendication 1, l'absorption de la lumière réfléchie passant à travers l'espace (16) augmentant l'irradiance de la face arrière de 5 à 10 pour cent.

6. Suiveur solaire (10) selon la revendication 1, l'absorption de la lumière réfléchie passant à travers la fente (16) augmentant l'irradiance de la face arrière d'environ 10 pour cent.
